# EUROPEAN PATENT APPLICATION

(11) **EP 3 483 301 A1**
(43) Date of publication of application: **15.05.2019**
(21) Application number: 18197106.0
(22) Date of filing: 27.09.2018
(51) Int. Cl.: C23C 14/54, C23C 14/56, C23C 16/458, C23C 16/46, H01L 31/18, H01L 31/20

(54) **VACUUM COATING APPARATUS**

(30) Priority: 16.10.2017 CN 201721331755 U
(71) Applicant: Beijing Juntai Innovation Technology Co., Ltd, 100176 Beijing (CN)
(72) Inventor: YANG, Bin, Beijing, 100176 (CN)
(74) Representative: Nordmeyer, Philipp Werner

(57) **Abstract**

A vacuum coating apparatus includes a working chamber (1) configured to accommodate a substrate (4) therein. A heater (5), a first temperature sensor (6) and at least one second temperature sensor (7) is provided in the working chamber (1). The first temperature sensor (6) is configured to measure a temperature of the heater (5). The second temperature sensor (7) is configured to measure an ambient temperature within the working chamber (1).

## Description

### CROSS-REFERENCE TO RELATED APPLICATIONS

This application claims a priority of Chinese patent application No. 201721331755.5, titled by "vacuum coating apparatus" and filed with China Patent Office on October 16, 2017, the entirety of which is incorporated herein by reference.

### Field of the Disclosure

The present disclosure relates to a field of solar cell manufacture, and particularly relates to a vacuum coating apparatus.

### Background of the Disclosure

Temperature is one of the important parameters during the preparation of thin film solar cells. A thin film cell manufacturing apparatus includes a physical vapor deposition (PVD) apparatus, a copper indium gallium selenide (CIGS) evaporation apparatus and other apparatuses.

### Summary of the Disclosure

Some embodiments of the present disclosure provide a vacuum coating apparatus including a working chamber configured to accommodate a substrate therein, wherein a heater, a first temperature sensor configured to measure a temperature of the heater and at least one second temperature sensor configured to measure an ambient temperature within the working chamber are provided in the working chamber.

In some embodiments, the heater is disposed at a top of the working chamber, and the at least one second temperature sensor is disposed at a bottom of the working chamber.

In some embodiments, the heater is disposed at a top of the working chamber, and the at least one second temperature sensor is disposed at a side wall of the working chamber.

In some embodiments, an opening is provided in a top of the working chamber, the vacuum coating apparatus further includes a top cover configured to close the opening, the heater is disposed on a side of the top cover adjacent to an interior of the working chamber, and the first temperature sensor is disposed at the top of the working chamber.

In some embodiments, the heater is a heating wire.

In some embodiments, the vacuum coating apparatus further includes a temperature controller configured to receive a first measurement value of the first temperature sensor and a second measurement value of the at least one second temperature sensor, calculate a temperature at the substrate based on the first measurement value and the second measurement value, and generate an instruction for controlling the heater to adjust a heating power based on the temperature at the substrate.

In some embodiments, the temperature controller is further configured to calculate the temperature at the substrate based on the first measurement value and the second measurement value as well as a thermal field simulation model in the working chamber.

In some embodiments, the temperature controller is further configured to build a thermal field simulation model in the working chamber based on the first measurement value and the second measurement value and then calculate the temperature at the substrate according to the thermal field simulation model.

In some embodiments, the temperature controller is further configured to determine whether the temperature at the substrate is within a preset process temperature range and generate the instruction to adjust the heating power of the heater till the temperature at the substrate is within the process temperature range when it is determined that the temperature at the substrate is not within the process temperature range.

In some embodiments, the vacuum coating apparatus further includes a sealing gasket configured to seal a gap between the top cover and the opening and fix the top cover.

In some embodiments, the heating wire is welded to the top cover.

In some embodiments, the second temperature sensor is welded to the bottom of the working chamber.

In some embodiments, the first temperature sensor is wound around and fixed to the heater.

In some embodiments, a mounting hole is provided in a bottom of the working chamber, and the second temperature sensor disposed at the bottom of the working chamber is fixed into the mounting hole.

In some embodiments, the second temperature sensor is fixed into the mounting hole by a bolt.

### Brief Description of the Drawings

The drawings described herein are given to provide a further comprehension of the present disclosure and constitute a part of the present disclosure. The exemplary embodiments of the present disclosure and the description thereof are used to explain the present disclosure and are not intended to restrict the present disclosure. In the drawings:
Fig. 1 is a schematic diagram of a vacuum coating apparatus according to some embodiments of the present disclosure;
Fig. 2 is a schematic diagram of another vacuum coating apparatus according to some embodiments of the present disclosure;
Fig. 3 is an enlarged diagram of a local portion A of Fig. 1; and
Fig. 4 is a schematic structural diagram of a working chamber according to some embodiments of the present disclosure.

### Detailed Description of the Preferred Embodiments

The embodiments of the present disclosure are described in detail below, and examples of the embodiments are illustrated in the drawings throughout which the same or similar reference numerals are used to indicate the same or similar components or components having the same or similar functions. The embodiments described below with reference to the drawings are intended to be exemplary, are only used to explain the present disclosure but are not to be construed as limiting.

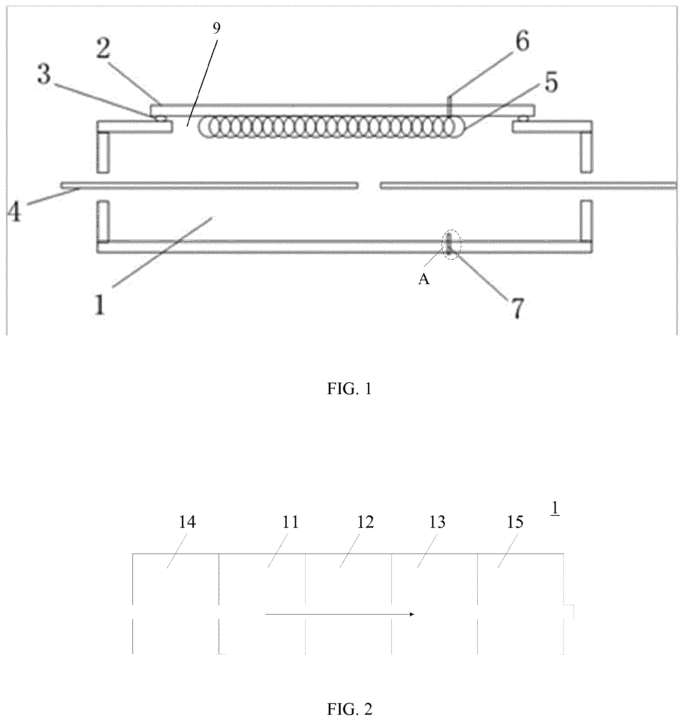

Some embodiments of the present disclosure provide a vacuum coating apparatus, and as shown in Fig. 1, the vacuum coating apparatus includes a working chamber 1 configured to accommodate a substrate 4 therein. Wherein a heater 5, a first temperature sensor 6 configured to measure a temperature of the heater and at least one second temperature sensor 7 configured to measure an ambient temperature within the working chamber 1 are provided in the working chamber 1.

The ambient temperature of the working chamber 1 alters due to a change in a temperature of a wall of the chamber, maintenance of the chamber, replacement of components, or a long-term process, which causes an alteration of a temperature at a position where the substrate is located. In regard to this problem, the embodiments of the present disclosure are intended to facilitate subsequent modification of the ambient temperature by feedback of the first temperature sensor 6 and the second temperature sensor 7 so that a constant temperature at the substrate 4 is ensured to guarantee favourable process results. A plurality of second temperature sensors 7 may be provided. The specific positions in which the second temperature sensors 7 are provided are not limited, and can be set by those skilled in the art as actually required.

The heating of the substrate by a thin film process apparatus is mainly performed by radiation heating of the heater and the chamber as well as conduction heating of air. The process apparatus is in a high vacuum state, and an influence of conduction heating of air is very small. Therefore, the temperature of the substrate is mainly derived from radiation of the heater at a top of the chamber and radiation of a bottom of the chamber. The temperature of the heater is measured by the first temperature sensor 6 and a temperature of a specific point in an internal space of the working chamber is measured by the second temperature sensor 7 so that the ambient temperature in the working chamber 1 is measured. The specific point refer to a position where the second temperature sensor 7 is located, and a distance between the second temperature sensor 7 and the first temperature sensor 6 is known. In case of the plurality of second temperature sensors 7, the ambient temperature in the working chamber 1 is determined based on the temperature of each specific point respectively measured by the plurality of second temperature sensors 7, for example, the ambient temperature in the working chamber 1 is obtained by averaging, or averaging after eliminating the highest and lowest temperatures or the like.

The spatial temperature at the substrate 4 may be determined based on the measured temperature of the heater and the measured temperatures at the specific points by heating simulation or experimental measurement. In this way, if an environment in the chamber changes, the temperature control procedure can be modified by the feedback of the first temperature sensor 6 and the second temperature sensor 7 so that a constant temperature at the substrate 4 is ensured to guarantee favorable process results.

In some embodiments, a thermal field simulation model in the working chamber may be built based on a first measurement value of the first temperature sensor 6 and a second measurement value of the second temperature sensor 7, and the temperature at the substrate is then calculated according to the thermal field simulation model. Therefore, the position in which the second temperature sensor 7 is provided can be optimized in accordance with the requirements that contribute to better building of the thermal field simulation model. In case of the plurality of second temperature sensors 7, the thermal field simulation model in the working chamber is built based on the second measurement values respectively measured by the plurality of second temperature sensors 7 and the first measurement value measured by the first temperature sensor 6. For example, the ambient temperature in the working chamber 1 is determined based on the second measurement values respectively measured by the plurality of second temperature sensors 7, and the thermal field simulation model in the working chamber is built based on the ambient temperature in the working chamber 1 and the first measurement value of the first temperature sensor 6.

In some embodiments of the present disclosure, the second temperature sensor 7 is disposed on an inner wall of the working chamber 1 remote from the first temperature sensor 6. For example, when the heater is disposed at the top of the working chamber, the second temperature sensor 7 is disposed at the bottom or a side wall of the working chamber 1.

In some embodiments of the present disclosure, as shown in Fig. 1, the vacuum coating apparatus includes the working chamber 1 for housing the substrate 4 therein. An opening 9 which is closed by a top cover 2 is provided in the top of the working chamber 1. The heater 5 is disposed on a side of the top cover 2 adjacent to an interior of the working chamber 1, the first temperature sensor 6 is disposed at the top of the working chamber 1, and one of the at least one second temperature sensor 7 is disposed at the bottom of the working chamber 1. In the embodiments of the present disclosure, the opening 9 and the top cover 2 are provided to facilitate provision and replacement of the heater 5. Moreover, a special heat resistant material may be selected to form the top cover 2 mounted with the heater.

The substrate 4 enters the working chamber 1 from one side of the working chamber and exits from the other side of the working chamber 1. In some embodiments, as shown in Fig. 2, the working chamber 1 includes a heating chamber 11, a process chamber 12 and a cooling chamber 13, and the heating chamber 11, the process chamber 12 and the cooling chamber 13 are used together to complete the coating process of the substrate. In some embodiments, the vacuum coating apparatus further includes an entrance chamber 14 and an exit chamber 15. The arrow shown in Fig. 2 indicates a traveling direction of the substrate 4. In some embodiments, the heater 5, the first temperature sensor 6 and the second temperature sensor 7 are disposed within the process chamber.

In some embodiments, the heater 5 is a heating wire 5.

In some embodiments, the heating wire 5 is welded to the top cover 2. In other embodiments, the heating wire 5 is secured to the top cover 2 by other means.

The first temperature sensor 6 is configured to measure the temperature of the heating wire 5. In some embodiments, one end of the first temperature sensor 6 passes through the top cover 2 and the other end of the first temperature sensor 6 is located between the heating wire 5 and the top cover 2. In other embodiments, in order to facilitate installation of the first temperature sensor 6 and reduce the installation process difficulty and the installation cost, the first temperature sensor 6 is wound around the heating wire 5.

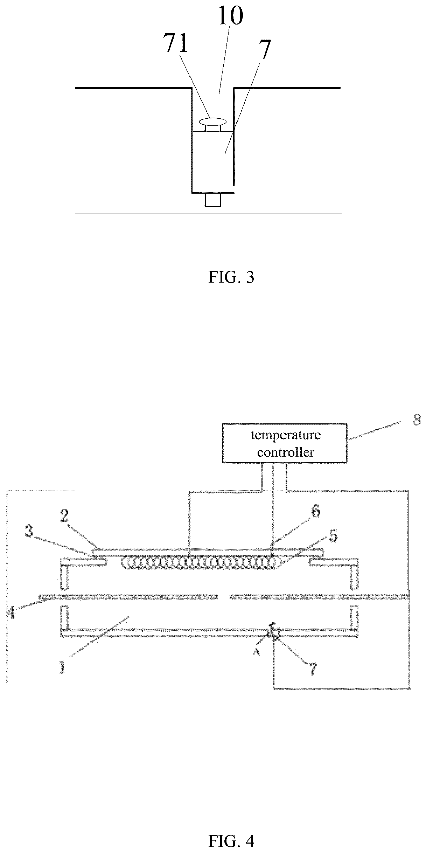

The second temperature sensor 7 is configured to measure the ambient temperature within the working chamber 1. In some embodiments, the second temperature sensor 7 is fixedly welded to the bottom of the working chamber 1. In other embodiments, the second temperature sensor 7 is secured by other means. In some examples, as shown in Fig. 3, a mounting hole 10 is provided in the bottom of the working chamber 1, and the second temperature sensor 7 disposed at the bottom of the working chamber is fixed into the mounting hole 10. For example, the second temperature sensor 7 is fixed into the mounting hole 10 by a bolt 71.

In some embodiments, the first temperature sensor 6 and the second temperature sensor 7 both employ thermocouples. Certainly, other devices may also be used to achieve temperature acquisition.

In some embodiments, as shown in Fig. 4, the vacuum coating apparatus further includes a temperature controller 8, and the temperature controller 8 is configured to receive the first measurement value of the first temperature sensor 6 and the second measurement value of the at least one second temperature sensor 7, calculate the temperature at the substrate 4 based on the first measurement value and the second measurement value, and generate an instruction for controlling the heater 5 to adjust a heating power based on the calculated temperature at the substrate 4.

In some embodiments, the temperature controller 8 is further configured to calculate the temperature at the substrate 4 based on the first measurement value and the second measurement value as well as an existing thermal field simulation model in the working chamber 1, or to build the thermal field simulation model based on the first measurement value and the second measurement value and then calculate the temperature at the substrate 4 according to the thermal field simulation model.

When the vacuum coating apparatus provided by the embodiments of the present disclosure is operated, the first temperature sensor 6 senses the temperature of the heating wire 5 and the second temperature sensor 7 senses the ambient temperature in the working chamber 1. In this way, when the ambient temperature of the working chamber 1 changes, a temperature T1 measured by the first temperature sensor 6 and a temperature T2 measured by the second temperature sensor 7 are used to build the thermal field simulation model, or the temperature T1 measured by the first temperature sensor 6 and the temperature T2 measured by the second temperature sensor 7 are used in combination with pre-stored existing data to build the thermal field simulation model, and the temperature at the substrate 4 is then calculated according to the thermal field simulation model. The existing data used in building the thermal field simulation model may not be necessary, but in order to achieve more accurate temperature control, for example, such existing data may include, but is not limited to, information of an internal structure of the working chamber 1 and radiation characteristic information of the internal structure, and may also include some temperature data measured during the previous process. In other words, when a heating simulation experiment is initially performed, a large amount of data input is generally required to be obtained to build a temperature database corresponding to the thermal field simulation model. For temperatures measured subsequently, corresponding results can be directly called from the temperature database, and no simulation experiment is needed any more.

In some embodiments, the thermal field simulation model described above is a 3D thermal field simulation model of the working chamber 1. The 3D thermal field simulation model is built based on mechanical 3D drawings of an actual apparatus, and the temperatures T1 and T2 are used as a group of inputs for simulation calculation of the simulation model.

In some embodiments, the temperature controller 8 is further configured to determine whether the temperature at the substrate 4 is within a preset process temperature range and generate the instruction to adjust the heating power of the heater (the heating wire) 5 till the temperature at the substrate 4 is within the process temperature range when it is determined that the temperature at the substrate 4 is not within the process temperature range.

When a temperature T3 at the substrate is obtained and then compared with an end value of the process temperature range by the temperature controller 8, if the temperature T3 is not within the process temperature range, the heating power of the heating wire is adjusted. The above comparison and adjustment steps are repeated till the temperature T3 at the substrate is within the process temperature range. Thus, the accuracy of the temperature measurement is increased, thereby improving the process quality. The process temperature range is a temperature range in process parameters set by a process personnel, and can be input to the temperature controller 8 or a host communicatively connected to the temperature controller 8 through an operation interface.

In order to ensure the tightness between the top cover 2 and the opening as much as possible, in some embodiments, the vacuum coating apparatus further includes a sealing gasket 3 disposed between the top cover 2 and the opening, and the sealing gasket 3 is configured to seal a gap between the top cover 2 and the opening and fix the top cover 2.

In some embodiments, as shown in Fig. 1, the first temperature sensor 6 has a set distance from the bottom of the working chamber 1 in accordance with the requirements for sizes and temperature test of the working chamber 1. The distance between the first temperature sensor 6 and the bottom of the working chamber 1 is constant, which can ensure that a thermal field formed by the first temperature sensor 6 in the working chamber 1 keeps unchanged, that is, the corresponding temperature database is valid. If this distance is adjusted, the temperature simulation experiment needs to be redone and the database needs to be rebuilt.

In some embodiments, the heating wire 5 is provided to extend along the traveling direction of the substrate 4 to heat the substrate 4 more broadly and uniformly. In order to achieve the uniformity of the temperature test, in some embodiments, the plurality of second temperature sensors 7 may be provided, and the plurality of second temperature sensors 7 may be evenly distributed at the bottom of the working chamber 1.

The configurations, features and effects of the embodiments of the present disclosure are described in detail above with reference to the embodiments shown in the drawings. The above embodiments are only some of the embodiments of the present disclosure, but the present disclosure is not limited in its scope to the embodiments shown in the drawings. Any changes or modifications that are made in accordance with the concept of the present disclosure without going beyond the spirit covered by the description and the drawings are equivalent embodiments that are alternative, and are to be included within the scope of the present disclosure.

## Claims

1. A vacuum coating apparatus comprising:
a working chamber (1) configured to accommodate a substrate (4) therein,
wherein a heater (5), a first temperature sensor (6) configured to measure a temperature of the heater (5) and at least one second temperature sensor (7) configured to measure an ambient temperature within the working chamber (1) are provided in the working chamber (1).

2. The vacuum coating apparatus according to claim 1, wherein the heater (5) is disposed at a top of the working chamber (1), and the at least one second temperature sensor (7) is disposed at a bottom of the working chamber (1).

3. The vacuum coating apparatus according to claim 1, wherein the heater (5) is disposed at a top of the working chamber (1), and the at least one second temperature sensor (7) is disposed at a side wall of the working chamber (1).

4. The vacuum coating apparatus according to claim 1 or 2, wherein an opening (9) is provided in a top of the working chamber (1), the vacuum coating apparatus further comprises a top cover (2) configured to close the opening (9), the heater (5) is disposed on a side of the top cover (2) adjacent to an interior of the working chamber (1), and the first temperature sensor (6) is disposed at the top of the working chamber (1).

5. The vacuum coating apparatus according to any one of claims 1 to 4, wherein the heater (5) is a heating wire (5).

6. The vacuum coating apparatus according to any one of claims 1 to 5, further comprising:
a temperature controller (8) configured to receive a first measurement value of the first temperature sensor (6) and a second measurement value of the at least one second temperature sensor (7), calculate a temperature at the substrate (4) based on the first measurement value and the second measurement value, and generate an instruction for controlling the heater (5) to adjust a heating power based on the temperature at the substrate (4).

7. The vacuum coating apparatus of claim 6, wherein the temperature controller (8) is further configured to calculate the temperature at the substrate (4) based on the first measurement value and the second measurement value as well as a thermal field simulation model in the working chamber (1).

8. The vacuum coating apparatus of claim 6, wherein the temperature controller (8) is further configured to build a thermal field simulation model in the working chamber (1) based on the first measurement value and the second measurement value and then calculate the temperature at the substrate (4) according to the thermal field simulation model.

9. The vacuum coating apparatus according to any one of claims 6 to 8, wherein the temperature controller (8) is further configured to determine whether the temperature at the substrate (4) is within a preset process temperature range and generate the instruction to adjust the heating power of the heater (5) till the temperature at the substrate (4) is within the process temperature range when it is determined that the temperature at the substrate (4) is not within the process temperature range.

10. The vacuum coating apparatus according to claim 5, wherein the vacuum coating apparatus further comprises a sealing gasket (3) configured to seal a gap between the top cover (2) and the opening (9) and fix the top cover (2).

11. The vacuum coating apparatus according to claim 5, wherein the heating wire (5) is welded to the top cover (2).

12. The vacuum coating apparatus according to claim 2, wherein the second temperature sensor (7) is welded to the bottom of the working chamber (1).

13. The vacuum coating apparatus according to claim 5, wherein the first temperature sensor (6) is wound around and fixed to the heater (5).

14. The vacuum coating apparatus according to claim 1 or 2, wherein a mounting hole (10) is provided in a bottom of the working chamber (1), and the second temperature sensor (7) disposed at the bottom of the working chamber (1) is fixed into the mounting hole (10).

15. The vacuum coating apparatus according to claim 15, wherein the second temperature sensor (7) is fixed into the mounting hole (10) by a bolt (71).
